# EUROPEAN PATENT SPECIFICATION

(11) **EP 2 258 047 B1**
(45) Date of publication and mention of the grant of the patent: **17.08.2011**
(21) Application number: 09715323.3
(22) Date of filing: 19.02.2009
(51) Int. Cl.: H03L 7/08, H03L 7/085

(54) **FREQUENCY SYNTHESIS**
FREQUENZSYNTHESE
SYNTHÈSE DE FRÉQUENCE

(30) Priority: 28.02.2008 EP 08290203
(43) Date of publication of application: 08.12.2010
(73) Proprietor: NXP B.V., 5656 AG Eindhoven (NL)
(72) Inventor: RIDGERS, Timothy, John, NL-5656 AG Eindhoven (NL)
(74) Representative: Schouten, Marcus Maria
(86) International application number: PCT/IB2009/050687
(87) International publication number: WO 2009/107044

(56) References cited:
- JP-A- 6 077 822
- US-A1- 2002 158 696
- US-A1- 2006 256 910

## Description

### FIELD OF THE INVENTION

The invention relates to a frequency synthesiser, a wireless transmitter and receiver comprising a frequency synthesiser, and a method of frequency synthesis.

### BACKGROUND OF THE INVENTION

Architectures for wireless transmitters and receivers commonly require the generation of reference signals at two frequencies, a radio frequency (RF) signal at a carrier frequency and an intermediate frequency (IF) signal at a lower frequency.

For example, the well-known "near-zero IF" radio receiver architecture used in cellular telephones, cordless telephones, and connectivity applications, converts a received RF signal to a frequency close to DC by mixing the received signal with quadrature local oscillator signals in two parallel signal paths. Nominally the IF is set to a fixed frequency offset, for instance related to the channel spacing. Such a frequency choice enables relaxation of image rejection requirements for demodulation implemented within subsequent baseband circuits. It also moves the signal spectrum sufficiently from DC to allow straightforward filtering of DC offsets and low frequency noise, such as 1/f noise generated by a CMOS transistor. In a near-zero IF receiver, frequency generation must be of sufficient precision to enable the required frequency shifting, and to position the spectrum of the received wanted signal within the subsequent frequency window used for filtering and demodulation.

As another example, in the Cartesian transmitter architecture, baseband signals are created as in-phase and quadrature-phase (I and Q) vectors which are then transformed to RF by multiplication with local oscillator signals at a carrier frequency. For complex systems, the I and Q vectors are themselves constructed from multiple signals. For instance an orthogonal frequency division multiplex (OFDM) system requires multiple sub-carriers to be combined, each containing a part of the information to be transmitted.

Typically, a frequency synthesiser is used to generate the local oscillator signals based on a phase locked loop. A basic phase locked loop comprises a variable frequency oscillator having a control input for controlling the frequency of the oscillator. A signal generated by the oscillator is divided, and the phase of the divided oscillator signal is compared with the phase of a frequency reference signal by means of a phase comparator. An output signal of the phase comparator is smoothed in a low-pass filter and then applied to the control input of the oscillator. The divided oscillator signal is employed as a local oscillator signal.

In phase locked loops built using digital circuits, the oscillator can typically only assume discrete frequency values. An inductor-capacitor (LC) tank resonator sets the oscillation frequency. The inductor of the LC tank is patterned by a metal mask during integrated circuit manufacture and has a fixed value. With modem fine lithography the inductance value is well-known and well controlled. The capacitor is built from discrete elements that are coupled to the inductor. In addition there will be capacitance contributed by the active circuit and layout parasitics. The discrete frequency step is set by the size of the minimum capacitor that can be added to the resonator. Typical discrete capacitance values of only a few femtoFarads allow steps of at least several kiloHertz, on a 2GHz oscillator, depending on the resonator impedance level. This therefore directly determines the precision of the local oscillator frequency. Any error resulting from a difference between the required frequency and the set of available discrete frequencies will be corrected by the frequency synthesiser. It does so by hopping between capacitor values, either side of the wanted value, and hence hopping the frequency.On average this will give the correct "fractional" capacitance and hence on average generates the wanted frequency. In this process, which is often described as dithering, and known per se f.i. from US5,036,294 the capacitor hopping introduces an undesirable oscillator phase modulation, creating unwanted spectral components which deteriorate the receiver performance, or more importantly the transmit spectrum. Dithering may alternatively involve hopping the frequency between more than two frequency, for example according to a pseudorandom pattern, in order to spread the noise resulting from hopping.

US 6,658,748 discloses a scheme in which the oscillator frequency is finely tuned by dithering a smallest unity capacitor between two states, using a sigma-delta encoder clocked at a sub-multiple of the oscillator frequency. The sigma-delta encoder provides noise shaping to create a clean close-in oscillator spectrum. However, the circuit is complex to implement and, due to its high-frequency operation, has a high power consumption.

US 2006/0256910 A1 discloses a scheme in which the output of a transmitter is compared with a reference frequency signal and the result of the comparison is used to generate an oscillator tuning word (OTW). A fractional part of the OTW is used to control the frequency of a numerically controlled oscillator (NCO) that generates a first local oscillator signal, and an integer part of the OTW is used to control the frequency of a digitally controlled oscillator that generates a second local oscillator frequency for mixing the first local oscillator signal to a carrier frequency. Modulation is applied to the first local oscillator signal prior to the mixing. The scheme is described for only a transmitter, the scheme employing the output of the transmitter.

An object of the invention is to provide improvements in frequency synthesis.

### SUMMARY OF THE INVENTION

According to a first aspect of the invention there is provided a frequency synthesiser comprising:
- a first variable frequency oscillator for generating a first oscillator signal having a frequency responsive to a first control signal;
- a second variable frequency oscillator for generating a second oscillator signal having a frequency responsive to a second control signal;
- a phase reference generator for generating a phase reference signal;
- a phase difference generator for generating a phase difference signal indicative of the phase difference between the sum of the phases of the first and second oscillator signals and the phase of the phase reference signal; and
- a controller responsive to the phase difference signal for generating the first control signal and the second control signal;
wherein the controller is adapted to determine at least one of the first control signal and the second control signal dependent on a value of the phase difference signal;
wherein the controller is adapted to determine at least one of the first control signal and the second control signal dependent on a further characteristic of a signal, and wherein the further characteristic is supplementary to the effect of any dithering optionally introduced into the frequency synthesiser.

According to a second aspect of the invention there is provided a method of frequency synthesis comprising:
- generating a first oscillator signal having a frequency responsive to a first control signal;
- generating a second oscillator signal having a frequency responsive to a second control signal;
- generating a phase reference signal;
- generating a phase difference signal indicative of the phase difference between the sum of the phases of the first and second oscillator signals and the phase of the phase reference signal;
- generating the first control signal and the second control signal in response to the phase difference signal;
- determining at least one of the first control signal and the second control signal dependent on a value of the phase difference signal; and
- determining at least one of the first control signal and the second control signal dependent on a further characteristic of a signal, wherein the further characteristic is supplementary to the effect of any dithering optionally introduced into the frequency synthesis.

Thus the frequencies of the first and/or second oscillator signals are dependent not only on the phase difference between the phase of the phase reference signal and the sum of the phases of the first and second oscillator signals, but also on a further characteristic of a signal. If dithering is introduced into the frequency synthesis, the further characteristic is supplementary to the effect of the dithering.

Such a frequency synthesiser or method of frequency synthesis provides increased scope for adapting and optimising the performance of synthesised frequencies.

Optionally, the further characteristic of a signal may be a measured parameter of the phase difference signal, for example the rate of change of the phase difference signal. Thus the frequency synthesiser and method of frequency synthesis may take into account parameters other than simply a value of the phase difference signal.

For example, the controller may be adapted to, in response to the rate of change of the phase difference signal exceeding a threshold, apply a limit to the rate of change of at least one of the first control signal and the second control signal. In this way the maximum rate of change of the frequency of the synthesised signal may be constrained, for example to constrain the spectrum of the synthesised signal.

The limits applied to the rate of change of the first control signal and the second control signal may be different. This enables independent control of the first oscillator signal and second oscillator signal for optimising performance, such as spectrum or switching speed.

Optionally, the further characteristic of a signal may be indicative of a manufacturing process tolerance. Thus account may be taken of variations resulting from manufacturing process tolerances, such as the spread of component values, thereby resulting in a more precise synthesised frequency.

Optionally, the further characteristic of a signal may be indicative of a temperature. Thus account may be taken of variations resulting from temperature variations, such as the spread of component values, thereby resulting in a more precise synthesised frequency.

Optionally, the further characteristic of a signal may be indicative of a supply voltage. Thus account may be taken of variations resulting from supply voltage variations, thereby resulting in an improved synthesised frequency.

Optionally, the further characteristic of a signal may be information conveyed by a received wireless signal. For example, the information conveyed by the received wireless signal may be indicative of a required operating performance, such as a frequency precision, a minimum frequency switching time or a maximum noise level. Thus the performance of the synthesised frequency may be adapted according to external requirements.

Optionally, the frequency synthesiser may comprise a phase estimator for generating a first indication of the phase of the first oscillator signal, and the second variable frequency oscillator may be adapted to provide a second indication of the phase of the second oscillator signal, and the phase difference generator may be adapted to employ the first and second indications for generating the phase difference signal. Thus indications of the phases of the first and second oscillator signals may be provided separately, which provides a useful degree of freedom in embodiments of the invention, in particular flexibility in generating independently the frequencies required for transmit and receive in a time division duplex system.

Optionally, the controller may comprise at least one of a first filter for filtering the first control signal and a second filter for filtering the second control signal. Thus different time constants may be applied to the first and second control signals, enabling optimisation of loop performance.

Optionally, the first variable frequency oscillator may be a digitally controlled oscillator and the first control signal may be a first digital word. This contributes to high precision frequency control.

Optionally, the second variable frequency oscillator may be a numerically controlled oscillator and the second control signal may be a second digital word. This enables a simple control of phase and frequency with high precision.

Optionally, the phase difference signal may be a digital word and the controller may be adapted to divide the digital word into a most significant portion and a least significant portion and to determine the first control signal dependent on the most significant portion and the second control signal dependent on the least significant portion, the controller being adapted to vary the division of the digital word dependent on the value of the digital word. This provides flexibility to control either the first or second variable frequency oscillator which enables optimum use of the tuning ranges of the oscillators.

The invention also provides a wireless receiver comprising a frequency synthesiser according to the first aspect of the invention, a first down-converter for employing the first oscillator signal to convert a received radio frequency signal to an intermediate frequency signal, and a second down-converter for employing the second oscillator signal to convert the intermediate frequency signal to baseband.

The invention also provides a wireless transmitter comprising a frequency synthesiser according to the first aspect of the invention, a first up-converter for employing the second oscillator signal to convert a baseband signal to an intermediate frequency signal, and a second up-converter for employing the first oscillator signal to convert the intermediate frequency signal to a radio frequency signal.

The present invention is particularly but not exclusively suitable for integration into a fully digital phase locked loop. It can be most advantageously implemented in a CMOS integrated circuit.

### BRIEF DESCRIPTION OF THE DRAWINGS

The invention will now be described, by way of example only, with reference to the accompanying drawings wherein:
Fig. 1 is block schematic diagram of a receiver comprising a frequency synthesiser;
Fig. 2 is block schematic diagram of a transmitter comprising a frequency synthesiser;
Fig. 3 is block schematic diagram of a frequency synthesiser;
Fig. 4 is block schematic diagram of a further embodiment of a frequency synthesiser;
Fig. 5 is block schematic diagram of a phase estimator; and
Fig. 6 is a flow chart of a method of frequency synthesis.

### DETAILED DESCRIPTION OF THE EMBODIMENTS

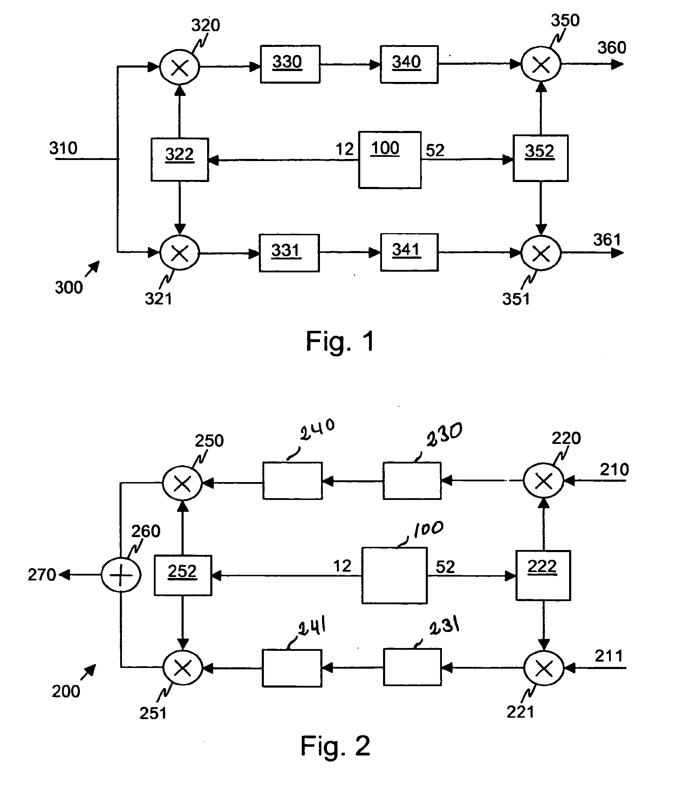

Referring to Fig. 1, there is illustrated a receiver comprising an input 310 for an RF received signal provided by a non-illustrated antenna. The input 310 is coupled to mixers 320, 321 for multiplying the RF received signal by respective quadrature components of an RF local oscillator signal. A first oscillator signal is provided by an output 12 of a frequency synthesiser 100 to a divider 322 which divides the first oscillator signal and provides the quadrature components of the RF local oscillator signal to the mixers 320, 321. The frequency of the first oscillator signal may be twice the required frequency of the RF local oscillator signal, in which case the divider 322 divides by two. This division ratio conveniently enables the quadrature components to be derived in a simple manner, although other ratios may alternatively be used.

Respective outputs of the mixers 320, 321 provide IF analogue I and Q signals, and these outputs are coupled to respective low-pass filters 330, 331 for filtering the IF analogue I and Q signals. Outputs of the low-pass filters 330, 331 are coupled to respective analogue-to-digital converters 340, 341 for converting the filtered IF analogue I and Q signals to the digital domain. Once in the digital domain, digital signal processing may be used to perform non-illustrated functions such as removing residual DC energy, further filtering out-of-band blocker signals, and adjusting gain to reduce dynamic range.

Outputs of the analogue-to-digital converters 340, 341 are coupled to respective further mixers 350, 351 for multiplying the IF digital I and Q signals by respective quadrature components of an IF digital local oscillator signal, thereby resulting in baseband I and Q modulation signals. A second oscillator signal is provided by an output 52 of the frequency synthesiser 100 in the form of phase values provided by an NCO phase accumulator. The phase values are converted to sine and cosine waveform quadrature components of the IF digital local oscillator signal by means of a look-up table 352 and these quadrature components are provided to the mixers 350, 351. The baseband I and Q modulation signals are delivered at respective outputs 360, 361 of the mixers 350, 351.

Referring to Fig. 2, there is illustrated a transmitter comprising inputs 210, 211 for, respectively, digital I and Q components of a baseband modulation signal. The inputs 210, 211 are coupled to respective mixers 220, 221 for multiplying the digital I and Q components of the baseband modulation signal by respective quadrature components of a digital IF local oscillator signal. A second oscillator signal is provided by an output 52 of a frequency synthesiser 100 in the form of phase values provided by a NCO phase accumulator. These phase values are converted to sine and cosine waveform quadrature components of the IF digital local oscillator signal by means of a look-up table 222 and these quadrature components are provided to the mixers 220, 221. Respective outputs of the mixers 220, 221 provide IF digital I and Q modulation signals, and these outputs are coupled to respective digital-to-analogue converters 230, 231 for converting the IF digital I and Q modulation signals to the analogue domain. Outputs of the digital-to-analogue converters 230, 231 are coupled to respective low-pass filters 240, 241 for filtering the IF analogue I and Q modulation signals. Outputs of the low-pass filters 240, 241 are coupled to respective further mixers 250, 251 for multiplying the filtered IF analogue I and Q modulation signals by respective quadrature components of an RF local oscillator signal, thereby resulting in RF I and Q signals. A first oscillator signal is provided by an output 12 of the frequency synthesiser 100 to a divider 252 which divides the first oscillator signal and provides the quadrature components of the RF local oscillator signal to the mixers 250, 251. As for the receiver described with reference to Figure 1, the frequency of the first oscillator signal may be twice the required frequency of the RF local oscillator signal, in which case the divider 252 divides by two. This division ratio conveniently enables the quadrature components to be derived in a simple manner, although other ratios may alternatively be used. Outputs of the mixers 250, 251 are coupled to a combiner 260 which sums the RF I and Q signals and delivers the resulting sum at an output 270. The output 270 may be coupled to a non-illustrated power amplifier and antenna for transmission.

The receiver and transmitter illustrated in Figs. 1 and 2 need not be interdependent, but may be deployed alone or in combination.

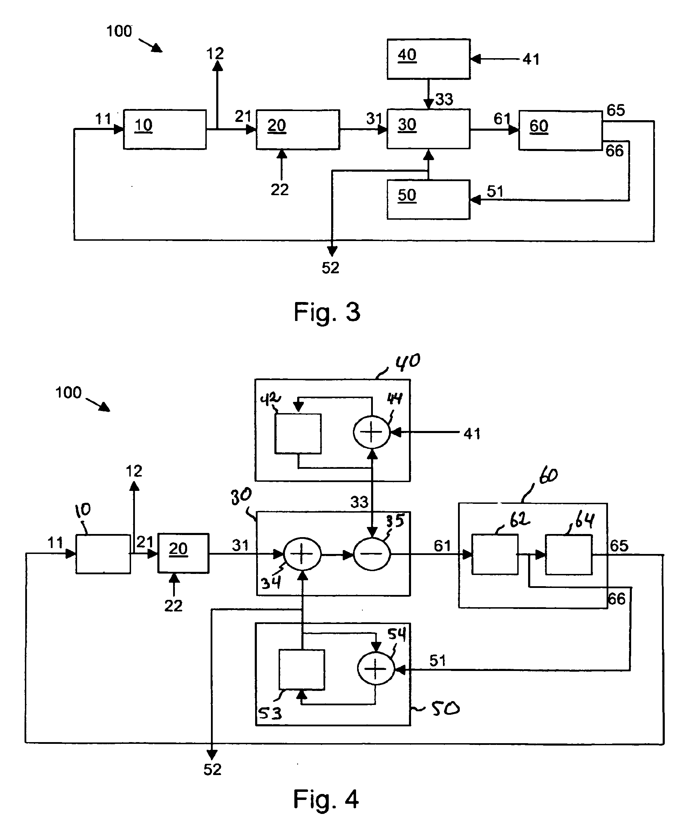

The frequency synthesiser 100 will be described initially in overview with reference to Fig. 3. The frequency synthesiser 100 comprises a first variable frequency oscillator 10 for generating, at an output 12, a first oscillator signal having a frequency dependent on a first control signal applied at an input 11. The first variable frequency oscillator 10 may be, for example, a digitally controlled oscillator, that is an oscillator comprising analogue circuitry but having its frequency determined by a digital word applied at its input. The output 12 of the first variable frequency oscillator 10 is coupled to a first input 21 of a phase estimator 20.

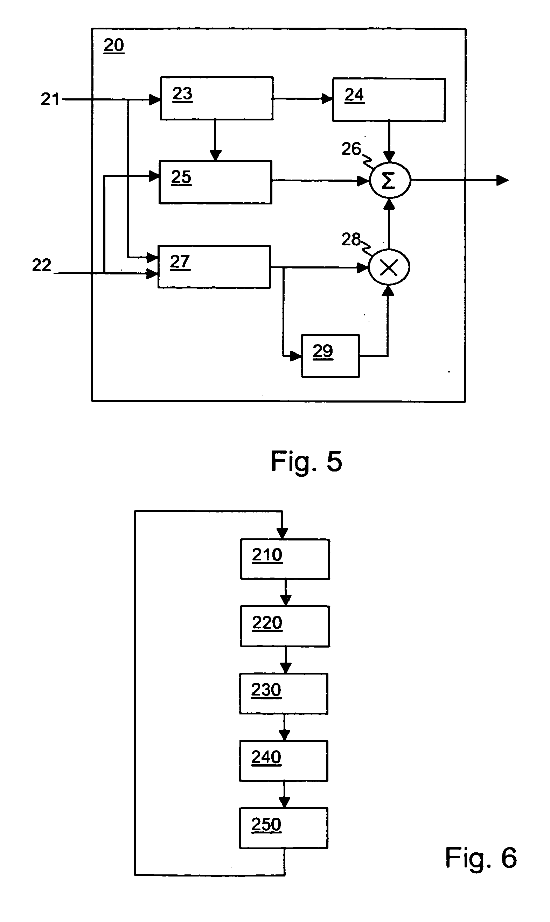

The phase estimator 20 is adapted to provide at an output an indication of the phase of the first oscillator signal at intervals defined by a reference clock applied at an input 22. An embodiment of the phase estimator 20 is illustrated in Fig. 5 and is described below. The output of the phase estimator 20 is coupled to a first input 31 of a phase difference generator 30 .

There is a second variable frequency oscillator 50 for generating, at an output 52, a second oscillator signal having a frequency dependent on a second control signal applied at an input 51. The second variable frequency oscillator 50 may be, for example, a numerically controlled oscillator, that is an oscillator comprising an accumulator which indicates the phase of the oscillator, and where the period of the oscillator is determined by an overflow value of the accumulator. The output 52 of the second variable frequency oscillator 50 is coupled to a second input of the phase difference generator 30.

There is a phase reference generator 40 for generating a phase reference signal at its output. The phase reference generator 40 may, for example, comprise a numerically controlled oscillator. The frequency of the phase reference signal defines, as a multiple of the frequency of the reference clock, the required transmit or receive frequency for a transmitter 200 or receiver 300 employing the frequency synthesiser 100, and may be selected by a frequency selection signal at an input 41 of the phase reference generator 40. The output of the phase reference generator 40 is coupled to a third input 33 of the phase difference generator 30.

The phase difference generator 30 is adapted to generate at its output a phase difference signal which indicates the phase difference between the sum of the phases of the first and second oscillator signals and the phase of the phase reference signal. The output of the phase difference generator 30 is coupled to an input 61 of a controller 60.

The controller 60 is adapted to, in response to the phase difference signal, generate the first control signal at a first output 65 which is coupled to the input 11 of the first variable frequency oscillator 10, and the second control signal at a second output 66 which is coupled to the input 51 of the second variable frequency oscillator 50. A function of the controller 60 is to determine, by adapting the first and second control signals, to what extent the first variable frequency oscillator 10 is adjusted and to what extent the second variable frequency oscillator 50 is adjusted. At least one of the first and second control signals is dependent on a value of the phase difference signal, and also at least one of the first and second control signals is dependent on a further characteristic of a signal provided to the controller 60. Further details about the architecture and operation of the controller 60 are described below.

The operation of the frequency synthesiser 100 is illustrated by the flow chart of Fig. 6. At step 210, the first oscillator signal is generated having a frequency responsive to the first control signal. At step 220, the second oscillator signal is generated having a frequency responsive to the second control signal. At step 230, the phase reference signal is generated. At step 240, the phase difference signal is generated indicative of the phase difference between the sum of the phases of the first and second oscillator signals and the phase of the phase reference signal. At step 250, the first control signal and the second control signal are generated in response to the phase difference signal, at least one of the first control signal and the second control signal being determined dependent on a value of the phase difference signal, and also at least one of the first control signal and the second control signal being determined dependent on a further characteristic of a signal, wherein the further characteristic is supplementary to the effect of any dithering introduced into the frequency synthesis. Flow then returns to step 210 and the operations are repeated, at intervals determined by the reference clock. The steps need not be performed in the precise order illustrated in Fig. 6.

Referring now to Fig. 4, the frequency synthesiser 100 illustrated in Fig. 4 includes all the features of the frequency synthesiser 100 of Fig. 3, for which corresponding reference numerals have been used, and illustrates some embodiments of the phase difference generator 30, the phase reference generator 40, the second variable frequency oscillator 50, and the controller 60.

The embodiment of the second variable frequency oscillator 50 illustrated in Fig. 4 is an NCO comprising a phase accumulator 53 having an output coupled to an input of an adder 54, and in which an output of the adder 54 is coupled to an input of the phase accumulator 53. A phase value in the phase accumulator 53 is incremented periodically in the adder 54 at intervals determined by the reference clock, and the incremented value is written into the phase accumulator 53. The size of the increment is determined by the second control signal provided at the input 51. The output of the phase accumulator 53 is coupled to the output 52 for providing the second oscillator signal from which the IF local oscillator signal may be derived.

The embodiment of the phase reference generator 40 illustrated in Fig. 4 is also an NCO comprising a phase accumulator 42 having an output coupled to an input of an adder 44, and in which an output of the adder 44 is coupled to an input of the phase accumulator 42. A phase value in the phase accumulator 42 is incremented periodically in the adder 44 at intervals determined by the reference clock, and the incremented value is written into the phase accumulator 42. The size of the increment is determined by the frequency selection signal provided at the input 41. The output of the phase accumulator 42 is coupled to the input 33 of the phase difference generator.

The embodiment of the phase difference generator 30 illustrated in Fig. 4 comprises an adder 34 having inputs coupled to the input 31 and to the output 52 of the second variable frequency oscillator 50 for calculating the sum of the phase of the first oscillator signal and the phase of the second oscillator signal. There is a subtractor 35 having inputs coupled to the input 33 and to an output of the adder 34 for calculating the difference between the sum calculated by the adder 34 and the phase of the phase reference signal.

Equivalent embodiments that produce the same result may alternatively be employed, in particular the phase of one of the first and second oscillator signals may first be subtracted from the phase of the phase reference signal, and then the phase of the other of the oscillator signals may be subtracted from the result. Furthermore, the location of the IF local oscillator signal above or below the spectrum of the received signal may be reversed by inverting the polarity of the input of the adder 34 coupled to the second variable frequency oscillator 50.

The embodiment of the controller 60 illustrated in Fig.4 comprises a phase error processor 62 which has an input coupled to the input 61 and an output coupled to the output 66 for providing the second control signal. The output of the phase error processor 62 is also coupled to an input of a low-pass filter 64, and an output of the low-pass filter 64 is coupled to the output 65 for providing the first control signal. Other arrangements of filters may alternatively be used. For example, a filter may also be provided for filtering the second output signal provided at the output 66. Also, the first and second control signals may be filtered using a common filter, or independent filters. These filters can reduce unwanted phase modulation introduced by quantisation noise of the phase estimator 20, which can typically be a significant fraction of a radian, and which can modulate the second variable frequency oscillator 50.

The frequency synthesiser 100 may apply a gain greater than unity to either the indication, at the output of the phase estimator 20, of the phase of the first oscillator signal, or the indication, in the accumulator 53, of the phase of the second oscillator signal, or both. These gains, which need not be identical, may be provided by the controller 60, and in particular by the filter 64 or filters. As a result of doing this, smaller phase errors are produced for a given frequency offset. In general, the filter 64 or filters should combine gain with an integrator in order to create a second order feedback loop. The operation of the phase error processor 62 of the controller 60 is described below.

The embodiment of the phase estimator 20 illustrated in Fig. 5 comprises a divider 23 having an input coupled to the input 21 for dividing the first oscillator signal. An output of the divider 23 is coupled to an input of a counter 24. The divider 23 counts active edges, for example rising edges, of the first oscillator signal and provides an overflow signal to the counter 24 when a maximum count value 2^{N} is reached, for an N-stage divider. There is also a state decoder 25 coupled to the divider 23 for reading the state of the divider 23.

The instants at which the state of the divider 23 is read is determined by the reference clock provided at the input 22, which is coupled to an input of the state decoder 25. The accumulated number of cycles of the first variable frequency oscillator 10 is indicated by the combination of the value in the counter 24 and the state of the divider 23 read by the state decoder 25. This combination may be regarded as comprising a most significant portion provided by the counter 24 and a less significant portion provided by the state decoder 25. These two portions are combined by an accumulator 26 which has an input coupled to an output of the counter 24 and an input coupled to an output of the state decoder 25. The combination of portions represents the accumulated phase of the first variable frequency oscillator 10 rounded down to the nearest 2n radians. For example, if the first variable frequency oscillator 10 operates at 4GHz, which is a suitable frequency for a GSM transceiver, the accumulated phase is determined with an accuracy of 250 picoseconds.

In order to provide phase information that has finer resolution than the period of the first variable frequency oscillator 10, that is to encode phase information below 2n, a Time-to-Digital Converter (TDC) 27 may be provided. A suitable TDC is described in US 6,429,693 B1. The TDC is coupled to the input 21 to receive the first oscillator signal and to the input 22 to receive the reference clock. The TDC 27 measures the time between edges of the reference clock and edges of the first oscillator signal. This may be implemented, for example, by using a set of nominally identical delay elements; in each cycle of the reference clock, an edge of the reference clock initiates a measurement and an edge of the first oscillator signal terminates the measurement. For instance, if each delay element delays the first oscillator signal by 25 picoseconds, the TDC 27 is able to measure phase to a resolution of 25 picoseconds. For a first variable frequency oscillator 10 which operates at 4GHz, this corresponds to a resolution of 0.2π radians. The increased resolution results in the phase measurement having a lower quantisation noise, and hence lower phase noise in the frequencies synthesised by the frequency synthesiser 100. The phase difference measured by the TDC 27 may be regarded as a least significant portion of the accumulated phase of the first variable frequency oscillator 10. An output of the TDC 27 is coupled to a further input of the accumulator 26, which combines this least significant portion with the most significant portion provided by the counter 24 and the less significant portion provided by the state decoder 25, and the resulting value of accumulated phase of provided at an output of the accumulator 26, which is coupled to the input 31 of the phase difference generator 30.

In some embodiments it may be necessary to normalise the delay introduced by the delay elements of the TDC 27 to the period of the first variable frequency oscillator 10, and to repeat the normalisation when the operating frequency of the first variable frequency oscillator 10 is changed, for example due to channel switching or transmit/receive switching. In order to provide this normalisation, in Fig. 5 the output of the TDC 27 is shown coupled to the accumulator 26 by means of an optional scaling stage 28 which scales the phase difference measured by the TDC 27 by a scaling factor. The required scaling factor is estimated by an optional gain normalising estimator 29 which is also coupled to the output of the TDC 27, and the scaling factor is provided to the scaling stage 28.

Further details about the operation of the frequency synthesiser 100, and in particular the controller 60, will now be described.

At each cycle of the reference clock, the phase difference generator 30 receives a measured value of the phase of the first oscillator signal, a value of the phase of the second oscillator signal, and a value of the phase of the phase reference signal, and generates from these a value of the phase difference signal, which is then processed by the controller 60.

The phase values should be coded with sufficient bits to permit the desired precision of frequency synthesis. For example, to create RF frequencies centred on 4GHz to a precision of a few tens of Hertz, the phase accumulator 42 and the adder 44 of the phase reference generator 40 should operate with 27-bit word precision. Part of the 27-bit word encodes complete cycles of the phase reference generator 40 per period of the reference clock, that is integer increments of 2π, and part encodes fractions of a cycle, that is phase information less than 2π radians. For instance for a reference clock operating at a frequency of 26MHz, which is a common frequency used in transceivers operating to the GSM standard, the number of cycles of a first variable frequency oscillator 10 operating at 4GHz that accumulate per period of the reference clock is about 156. In this case, the integer phase information can be encoded using 8 bits, leaving 19 of the 27 bits for encoding the fractional phase information.

For further illustration, consider that nominally the NCO of the second variable frequency oscillator 50 operates at a frequency of around 100kHz. This requires 260 periods of a 26MHz reference clock to cycle through a complete period of 2n radians. Hence the phase update word to the NCO of the second variable frequency oscillator 50 requires only, say, the ten or eleven least significant bits of the fractional phase information, and the remaining bits of the fractional phase information will contain only zeros.

The controller 60 is able, in response to the value of the phase difference signal, to adjust both the first and second variable frequency oscillators 10, 50 by means of the first and second control signals, at intervals of the reference clock period. Furthermore, the controller 60 is adapted to control either or both of the first and second control signals dependent on a further characteristic of a signal. In some embodiments dithering maybe introduced to signals in the frequency synthesiser 100 in order to shape the noise spectrum of the synthesised frequencies or to produce a desired average frequency. The further characteristic is supplementary to the effect of any such dithering. Some examples of such a further characteristic are described in the following paragraphs.
(a) The rate of change of the phase difference signal. This may be measured, for example, as the amount by which the phase difference signal changes between two or more successive measurements of the phase. A change by a predetermined amount over successive values is indicative of a frequency error in the first variable frequency oscillator, in which case the controller 60 adjusts the first oscillator frequency by applying a suitable adjustment to the first control signal. Furthermore, the controller 60 may apply a limit to the rate of change of either or both of the first and second control signals, to prevent a rapid change of frequency generating undesirable transient frequency components. The controller 60 may apply different limits to the rate of change of the first control signal and the second control signal in order to constrain the transient frequency components within required levels. These limits may be applied to the first control signal and the second control signal by filtering these signals with respective filters.
(b) An indication of the state of lock of the frequency synthesiser 100. Such an indication of lock may be provided by the peak-to-peak variation of the phase difference signal, which may be measured by the controller 60. During initial frequency lock, it may be preferable to keep the second variable frequency oscillator 50 operating at a fixed frequency and to adjust only the first variable frequency oscillator 10. Once the desired RF frequency has been acquired approximately by the first variable frequency oscillator 10, then the RF frequency is adjusted to a finer resolution by adjusting the second variable frequency oscillator 50, with zero or minimal further adjustment to the first variable frequency oscillator 10. As an alternative to detecting an out-of-lock state, receipt by the controller 60 of a command to change frequency channels may be interpreted for a predetermined period of time as an initial frequency lock state during which only the first variable frequency oscillator 10 is adjusted, following which the second variable frequency oscillator 50 may also be adjusted.
(c) An indication of a manufacturing process tolerance of an integrated circuit. Such an indication may be generated by an on-chip sensor which measures the deviation of a circuit parameter from a reference value.
(d) An indication of a temperature generated by means of a temperature sensor, which may be in an integrated circuit with the frequency synthesiser 100.
(e) An indication of a supply voltage. Such an indication may be generated by an on-chip voltage sensor.
(f) Information conveyed by a received wireless signal. Such information may be indicative of a required operating performance. This may be an explicit indication, such as a value of required frequency precision, minimum frequency switching time, or maximum noise level. Alternatively, this may be implicit, for example in a multi-mode application it may be an indication of which of several operating standards the frequency synthesiser should comply with, such as GSM, UMTS, WLAN. The controller 60 may then use a look-up table to convert the implicit indications into operating parameters, such as a value of required frequency precision, minimum frequency switching time, or maximum noise level.

The controller 60 may generate the first and second control signals such that large frequency changes are provided by the first variable frequency oscillator 10 and small frequency changes are provided by the second variable frequency oscillator 50. However, such a scheme may result in the oscillators reaching the end of their respective useful tuning ranges, so in some circumstances a preferable scheme can be to provide a range of intermediate frequency steps that can be covered by both the first and second variable frequency oscillators 10, 50. As an example, consider the first variable frequency oscillator 10 as a RF DCO operating at 4GHz and tunable across a range of 500MHz in steps of a few kiloHertz, and the second variable frequency oscillator 50 as an NCO operating up to 100MHz and with a frequency step size of a few Hertz. In this example, frequency steps between a few kiloHertz up to a few tens of megaHertz may be covered by either oscillator. The controller 60 may provide such operation by processing the phase difference signal as a digital word. The controller 60 may be adapted to divide the digital word into a most significant portion and a least significant portion and to determine the first control signal dependent on the most significant portion and the second control signal dependent on the least significant portion. In particular, the controller 60 may be adapted to vary the point at which the digital word is divided into the most significant portion and least significant portion dependent on the value of the digital word. Thus if a value of the digital word is detected that would cause one of the oscillators 10, 50 to operate at or near the end of its tuning range, the required frequency step size is provided by controlling the control signal of the other oscillator 101, 50. In effect, a central portion of the digital word may be allocated to the either of the oscillators, depending on the value of the digital word. In a further embodiment, for use in a wireless transmitter, the frequency synthesiser 100 may be frequency modulated by introducing modulation to the control of either or both of the first and second variable frequency oscillators 10, 50. When the frequency synthesiser 100 is employed in a transmitter or receiver for multi-carrier signals, the phase accumulator 53 of the second variable frequency oscillator 50, the look-up table 352 or 222, and the mixers 350, 351 and 220, 221 may be replicated for each sub-carrier signal, with modulation for each sub-carrier being applied to the respective one of the oscillators.

From reading the present disclosure, other variations and modifications will be apparent to the skilled person. Such variations and modifications may involve equivalent and other features which are already known in the art of phase locked loops, and which may be used instead of, or in addition to, features already described herein.

Features which are described in the context of separate embodiments may also be provided in combination in a single embodiment. Conversely, various features which are, for brevity, described in the context of a single embodiment, may also be provided separately or in any suitable sub-combination.

The applicant hereby gives notice that new claims may be formulated to such features and/or combinations of such features during the prosecution of the present application or of any further application derived therefrom.

For the sake of completeness it is also stated that the term "comprising" does not exclude other elements or steps, the term "a" or "an" does not exclude a plurality, a single processor or other unit may fulfil the functions of several means recited in the claims and reference signs in the claims shall not be construed as limiting the scope of the claims.

## Claims

1. A frequency synthesiser (100) comprising:
- a first variable frequency oscillator (10) for generating a first oscillator signal having a frequency responsive to a first control signal;
- a second variable frequency oscillator (50) for generating a second oscillator signal having a frequency responsive to a second control signal;
- a phase reference generator (40) for generating a phase reference signal;
- a phase difference generator (30) for generating a phase difference signal indicative of the phase difference between the sum of the phases of the first and second oscillator signals and the phase of the phase reference signal; and
- a controller (60) responsive to the phase difference signal for generating the first control signal and the second control signal;
- wherein the controller (60) is adapted to determine at least one of the first control signal and the second control signal dependent on a value of the phase difference signal;
wherein the controller (60) is adapted to determine at least one of the first control signal and the second control signal dependent on a further characteristic of a signal, and wherein the further characteristic is supplementary to the effect of any dithering optionally introduced into the frequency synthesiser (100).

2. A frequency synthesiser (100) as claimed in claim 1, wherein the further characteristic of a signal is indicative of at least one of a manufacturing tolerance a temperature and a supply voltage.

3. A frequency synthesiser (100) as claimed in claim 1, wherein the further characteristic of a signal is information conveyed by a received wireless signal.

4. A frequency synthesiser (100) as claimed in claim 3, wherein the information conveyed by the received wireless signal is indicative of a required operating performance.

5. A frequency synthesiser (100) as claimed in claim 4, wherein the required operating performance is at least one of a frequency precision, a minimum frequency switching time and a maximum noise level.

6. A frequency synthesiser (100) as claimed in any preceding claim,
- comprising a phase estimator (20) for generating a first indication of the phase of the first oscillator signal;
wherein the second variable frequency oscillator (50) is adapted to provide a second indication of the phase of the second oscillator signal; and
wherein the phase difference generator (30) is adapted to employ the first and second indications for generating the phase difference signal.

7. A frequency synthesiser (100) as claimed in any preceding claim, wherein the controller (60) comprises at least one of a first filter for filtering the first control signal and a second filter (64) for filtering the second control signal.

8. A frequency synthesiser (100) as claimed in any preceding claim, wherein the first variable frequency oscillator (10) is a digitally controlled oscillator and the first control signal is a first digital word.

9. A frequency synthesiser (100) as claimed in any preceding claim, wherein the second variable frequency oscillator (50) is a numerically controlled oscillator and the second control signal is a second digital word.

10. A frequency synthesiser (100) as claimed in any preceding claim,
wherein the phase difference signal is a digital word and the controller is adapted to divide the digital word into a most significant portion and a least significant portion and to determine the first control signal dependent on the most significant portion and the second control signal dependent on the least significant portion,
and wherein the controller is adapted to vary the division of the digital word dependent on the value of the digital word.

11. A wireless receiver (300) comprising a frequency synthesiser (100) as claimed in any preceding claim, comprising a first down-converter (320, 321) for employing the first oscillator signal to convert a received radio frequency signal to an intermediate frequency signal, and a second down-converter (350, 351) for employing the second oscillator signal to convert the intermediate frequency signal to baseband.

12. A wireless transmitter (200) comprising a frequency synthesiser (100) as claimed in any one of claims 1 to 10, comprising first a up-converter (220, 221) for employing the second oscillator signal to convert a baseband signal to an intermediate frequency signal, and a second up-converter (250, 251) for employing the first oscillator signal to convert the intermediate frequency signal to a radio frequency signal.

13. A method of frequency synthesis comprising:
- generating a first oscillator signal having a frequency responsive to a first control signal;
- generating a second oscillator signal having a frequency responsive to a second control signal;
- generating a phase reference signal;
- generating a phase difference signal indicative of the phase difference between the sum of the phases of the first and second oscillator signals and the phase of the phase reference signal;
- generating the first control signal and the second control signal in response to the phase difference signal;
- determining at least one of the first control signal and the second control signal dependent on a value of the phase difference signal; and
- determining at least one of the first control signal and the second control signal dependent on a further characteristic of a signal, wherein the further characteristic is supplementary to the effect of any dithering optionally introduced into the frequency synthesis.

## Patentansprüche

1. Frequenzsynthesizer (100) aufweisend:
- einen ersten variablen Frequenzoszillator (10) zum Erzeugen eines ersten Oszillatorsignals, das eine Frequenz reagierend auf ein erstes Steuersignal aufweist;
- einen zweiten variablen Frequenzoszillator (50) zum Erzeugen eines zweiten Oszillatorsignals, das eine Frequenz reagierend auf ein zweites Steuersignal aufweist;
- einen Phasenreferenzerzeuger (40) zum Erzeugen eines Phasenreferenzsignals;
- einen Phasendifferenzerzeuger (30) zum Erzeugen eines Phasendifferenzsignals, das indikativ für die Phasendifferenz zwischen der Summe der Phasen des ersten und zweiten Oszillatorsignals und der Phase des Phasenreferenzsignals ist; und
- einen Controller (60) reagierend auf das Phasendifferenzsignal zum Erzeugen des ersten Steuersignals und des zweiten Steuersignals;
- wobei der Controller (60) geeignet ist, zumindest eines von dem ersten Steuersignal und dem zweiten Steuersignal in Abhängigkeit von einem Wert des Phasendifferenzsignals zu bestimmen;
wobei der Controller (60) geeignet ist, zumindest eines von dem ersten Steuersignal und dem zweiten Steuersignal in Abhängigkeit von einer weiteren Charakteristik eines Signals zu bestimmen, und wobei die weitere Charakteristik ergänzend zu dem Effekt irgendeines Ditherings ist, das optional in den Frequenzsynthesizer (100) eingeführt wird.

2. Frequenzsynthesizer (100) gemäß Anspruch 1, wobei die weitere Charakteristik eines Signals indikativ für zumindest eines von einer Herstellungstoleranz, einer Temperatur und einer Versorgungsspannung ist.

3. Frequenzsynthesizer (100) gemäß Anspruch 1, wobei die weitere Charakteristik eines Signals Information ist, die durch ein empfangenes drahtloses Signal übertragen wird.

4. Frequenzsynthesizer (100) gemäß Anspruch 3, wobei die Information, die durch das empfangene drahtlose Signal übertragen wird, indikativ für eine benötigte Betriebsleistung ist.

5. Frequenzsynthesizer (100) gemäß Anspruch 4, wobei die benötigte Betriebsleistung zumindest eines von einer Frequenzpräzision, einer Minimalfrequenzschaltzeit und einem Maximalrauschpegel ist.

6. Frequenzsynthesizer (100) gemäß einem der vorhergehenden Ansprüche,
- aufweisend einen Phasenschätzer (20) zum Erzeugen einer ersten Anzeige der Phase des ersten Oszillatorsignals;
wobei der zweite variable Frequenzoszillator (50) geeignet ist, eine zweite Anzeige der Phase des zweiten Oszillatorsignals bereitzustellen; und
wobei der Phasendifferenzerzeuger (30) geeignet ist, die erste und zweite Anzeige zum Erzeugen des Phasendifferenzsignals zu verwenden.

7. Frequenzsynthesizer (100) gemäß einem der vorhergehenden Ansprüche, wobei der Controller (60) zumindest eines von einem ersten Filter zum Filtern des ersten Steuersignals und einem zweiten Filter (64) zum Filtern des zweiten Steuersignals aufweist.

8. Frequenzsynthesizer (100) gemäß einem der vorhergehenden Ansprüche, wobei der erste variable Frequenzoszillator (10) ein digital gesteuerter Oszillator ist und das erste Steuersignal ein erstes Digitalwort ist.

9. Frequenzsynthesizer (100) gemäß einem der vorhergehenden Ansprüche, wobei der zweite variable Frequenzoszillator (50) ein numerisch gesteuerter Oszillator ist und das zweite Steuersignal ein zweites Digitalwort ist.

10. Frequenzsynthesizer (100) gemäß einem der vorhergehenden Ansprüche,
wobei das Phasendifferenzsignal ein Digitalwort ist und der Controller geeignet ist, das Digitalwort in einen höchstwertigen Teil und einen niedrigstwertigen Teil zu teilen und das erste Steuersignal abhängig von dem höchstwertigen Teil und das zweite Steuersignal abhängig von dem niedrigstwertigen Teil zu bestimmen,
und wobei der Controller geeignet ist, die Teilung des Digitalworts abhängig von dem Wert des Digitalworts zu variieren.

11. Drahtloser Empfänger (300) aufweisend einen Frequenzsynthesizer (100) gemäß einem der vorhergehenden Ansprüche, aufweisend einen ersten Abwärtswandler (320, 321) zum Verwenden des ersten Oszillatorsignals, um ein empfangenes Hochfrequenzsignal in ein Zwischenfrequenzsignal umzuwandeln, und einen zweiten Abwärtswandler (350, 351) zum Verwenden des zweiten Oszillatorsignals, um das Zwischenfrequenzsignal in Basisband umzuwandeln.

12. Drahtloser Sender (200) aufweisend einen Frequenzsynthesizer (100) gemäß einem der Ansprüche 1 bis 10, aufweisend einen ersten Aufwärtswandler (220, 221) zum Verwenden des zweiten Oszillatorsignals, um ein Basisbandsignal in ein Zwischenfrequenzsignal umzuwandeln, und einen zweiten Aufwärtswandler (250, 251) zum Verwenden des ersten Oszillatorsignals, um das Zwischenfrequenzsignal in ein Hochfrequenzsignal umzuwandeln.

13. Verfahren zur Frequenzsynthese, aufweisend:
- Erzeugen eines ersten Oszillatorsignals, das eine Frequenz reagierend auf ein erstes Steuersignal aufweist;
- Erzeugen eines zweiten Oszillatorsignals, das eine Frequenz reagierend auf ein zweites Steuersignal aufweist;
- Erzeugen eines Phasenreferenzsignals;
- Erzeugen eines Phasendifferenzsignals, das indikativ für die Phasendifferenz zwischen der Summe der Phasen des ersten und zweiten Oszillatorsignals und der Phase des Phasenreferenzsignals ist;
- Erzeugen des ersten Steuersignals und des zweiten Steuersignals in Antwort auf das Phasendifferenzsignal;
- Bestimmen von zumindest einem von dem ersten Steuersignal und dem zweiten Steuersignal in Abhängigkeit von einem Wert des Phasendifferenzsignals; und
- Bestimmen von zumindest einem von dem ersten Steuersignal und dem zweiten Steuersignal in Abhängigkeit von einer weiteren Charakteristik eines Signals, wobei die weitere Charakteristik ergänzend zu dem Effekt irgendeines Dithering ist, das optional in die Frequenzsynthese eingeführt wird.

## Revendications

1. Synthétiseur de fréquence (100) comprenant :
- un premier oscillateur à fréquence variable (10) pour générer un premier signal d'oscillateur ayant une fréquence dépendant d'un premier signal de commande ;
- un deuxième oscillateur à fréquence variable (50) pour générer un deuxième signal d'oscillateur ayant une fréquence dépendant d'un deuxième signal de commande ;
- un générateur de phase de référence (40) pour générer un signal de référence de phase ;
- un générateur de différence de phase (30) pour générer un signal de différence de phase indicatif de la différence de phase entre la somme des phases des signaux du premier et du deuxième oscillateur et de la phase du signal de référence de phase ; et
- un contrôleur (60) répondant au signal de différence de phase pour générer le premier signal de commande et le deuxième signal de commande ;
- dans lequel le contrôleur (60) est agencé de manière à déterminer au moins l'un parmi le premier signal de commande et le deuxième signal de commande en fonction de la valeur du signal de différence de phase ;
dans lequel le contrôleur (60) est agencé de manière à déterminer au moins l'un parmi le premier signal de commande et le deuxième signal de commande en fonction d'une autre caractéristique du signal, et dans lequel l'autre caractéristique est complémentaire de l'effet d'un dithering introduit optionnellement dans le synthétiseur de fréquence (100).

2. Synthétiseur de fréquence (100) selon la revendication 1, dans lequel l'autre caractéristique du signal indique au moins une des tolérances de fabrication, une température et une tension d'alimentation.

3. Synthétiseur de fréquence (100) selon la revendication 1, dans lequel l'autre caractéristique d'un signal est une information transportée par un signal sans fil reçu.

4. Synthétiseur de fréquence (100) selon la revendication 3, dans lequel l'information transportée par le signal sans fil reçu indique une performance opérationnelle requise.

5. Synthétiseur de fréquence (100) selon la revendication 4, dans lequel la performance opérationnelle requise est une performance au moins parmi une précision de fréquence, un temps de commutation de fréquence minimum et un niveau de bruit maximum.

6. Synthétiseur de fréquence (100) selon l'une quelconque des revendications précédentes,
- comprenant un estimateur de phase (20) pour générer une première indication de la phase du premier signal d'oscillateur ;
dans lequel le deuxième oscillateur à fréquence variable (50) est agencé de manière à fournir une deuxième indication de la phase du deuxième signal d'oscillateur ; et dans lequel le générateur de différence de phase (30) est agencé de manière à utiliser les première et deuxième indications pour générer le signal de différence de phase.

7. Synthétiseur de fréquence (100) selon l'une quelconque des revendications précédentes, dans lequel le contrôleur (60) comporte au moins un premier filtre pour filtrer le premier signal de commande et un deuxième filtre (64) pour filtrer le deuxième signal de commande.

8. Synthétiseur de fréquence (100) selon l'une quelconque des revendications précédentes, dans lequel le premier oscillateur à fréquence variable (10) est un oscillateur à commande numérique et le premier signal de commande est un premier mot numérique.

9. Synthétiseur de fréquence (100) selon l'une quelconque des revendications précédentes, dans lequel le deuxième oscillateur à fréquence variable (50) est un oscillateur à commande numérique et le deuxième signal de commande est un deuxième mot numérique.

10. Synthétiseur de fréquence (100) selon l'une quelconque des revendications précédentes, dans lequel le signal de différence de phase est un mot numérique et dans lequel le contrôleur est agencé de manière à diviser le mot numérique en une partie la plus significative et une partie la moins significative et à déterminer le premier signal de commande en fonction de la partie la plus significative et le deuxième signal de commande en fonction de la partie la moins significative,
et dans lequel le contrôleur est agencé de manière à faire varier la division du mot numérique en fonction de la valeur du mot numérique.

11. Récepteur sans fil (300) comprenant un synthétiseur de fréquence (100) selon l'une quelconque des revendications précédentes, comprenant un premier convertisseur descendant (320, 321) utilisant le premier signal d'oscillateur pour convertir un signal radiofréquence reçu en un signal à une fréquence intermédiaire, et un deuxième convertisseur descendant (350, 351) utilisant le deuxième signal d'oscillateur pour convertir le signal de fréquence intermédiaire en signal en bande de base.

12. Emetteur sans fil (200) comprenant un synthétiseur de fréquence (100) selon l'une quelconque des revendications 1 à 10, comprenant un premier convertisseur montant (220, 221) utilisant le deuxième signal d'oscillateur pour convertir un signal en bande de base en un signal à fréquence intermédiaire, et un deuxième convertisseur montant (250, 251) utilisant le premier signal d'oscillateur pour convertir le signal de fréquence intermédiaire en signal radiofréquence.

13. Procédé de synthèse de fréquence comprenant :
- la génération d'un premier signal d'oscillateur ayant une fréquence dépendant d'un premier signal de commande ;
- la génération d'un deuxième signal d'oscillateur ayant une fréquence dépendant d'un deuxième signal de commande ;
- la génération d'un signal de référence de phase ;
- la génération d'un signal de différence de phase indicatif de la différence de phase entre la somme des phases des signaux du premier et du deuxième oscillateur et de la phase du signal de référence de phase ;
- la génération du premier signal de commande et du deuxième signal de commande en fonction du signal de différence de phase ;
- la détermination d'au moins l'un parmi le premier signal de commande et le deuxième signal de commande en fonction de la valeur du signal de différence de phase ; et
- la détermination d'au moins un parmi le premier signal de commande et le deuxième signal de commande en fonction d'une autre caractéristique du signal, et dans lequel l'autre caractéristique est complémentaire de l'effet d'un dithering introduit optionnellement dans la synthèse de fréquence.
